Europäisches Patentamt

European Patent Office

Office européen des brevets

(11) Veröffentlichungsnummer : **0 304 984 B1**

(12) **EUROPÄISCHE PATENTSCHRIFT**

(45) Veröffentlichungstag der Patentschrift :
15.01.92 Patentblatt 92/03

(51) Int. Cl.$^5$ : **G01N 24/08**, G01R 33/46

(21) Anmeldenummer : 88201700.7

(22) Anmeldetag : 09.08.88

(54) Volumenselektive Spektroskopie mittels nachfokussierter Echos.

(30) Priorität : 12.08.87 NL 8701889

(43) Veröffentlichungstag der Anmeldung :
01.03.89 Patentblatt 89/09

(45) Bekanntmachung des Hinweises auf die
Patenterteilung :
15.01.92 Patentblatt 92/03

(84) Benannte Vertragsstaaten :
CH DE FR GB IT LI

(56) Entgegenhaltungen :
EP-A- 0 144 871
EP-A- 0 184 840
EP-A- 0 186 392
US-A- 4 680 546
JOURNAL OF MAGNETIC RESONANCE, Band
72, Nr. 3, Mai 1987, Seiten 502-508, Academic
Press Inc., New York, US; J. FRAHM et al.:
"Localized proton spectroscopy using stimulated echoes"
"Two-dimensional nuclear magnetic resonance in liquids" Ad BAX; Delft University Press
(1984)

(73) Patentinhaber : N.V. Philips'
Gloeilampenfabrieken
Groenewoudseweg 1
NL-5621 BA Eindhoven (NL)

(72) Erfinder : Luyten, Peter Rudolf
Int. Octrooibureau B.V. Prof. Holstlaan 6
NL-5656 AA Eindhoven (NL)
Erfinder : Den Hollander, Jan Anthonie
Int. Octrooibureau B.V. Prof. Holstlaan 6
NL-5656 AA Eindhoven (NL)
Erfinder : Den Boef, Johannes Hendrik
Int. Octrooibureau B.V. Prof. Holstlaan 6
NL-5656 AA Eindhoven (NL)
Erfinder : Van Vaals, Johannes Jacobus
Int. Octrooibureau B.V. Prof. Holstlaan 6
NL-5656 AA Eindhoven (NL)

(74) Vertreter : Faessen, Louis Marie Hubertus et al
INTERNATIONAAL OCTROOIBUREAU B.V. 6
Prof. Holstlaan
NL-5656 AA Eindhoven (NL)

**Beschreibung**

Die Erfindung betrifft ein Verfahren zum Bestimmen einer wasserunterdrückten Kernmagnetisierungsverteilung wenigstens in einem Teil eines Objekts, wobei mittels einer Folge von Hochfrequenzimpulsen möglicherweise in Zusammenarbeit mit verschiedenen Gradientenmagnetfeldern wenigstens der Teil des Objekts angeregt und ein stimuliertes Echo erzeugt wird, das abgetastet wird.

Ein derartiges Verfahren läßt sich auch für Spektroskopiemessungen sowie für bildgebende Messungen anwenden, wobei auch Variooptiktechniken durch die Verwendung der selektiven Anregungsimpulse angewandt werden können, wie dies in einer Veröffentlichung von Frahm und anderen, Journal of Magnetic Resonance, 64, S. 81...93, 1985, beschrieben wird. Mit einer derartigen Impulsfolge kann ein geringer Teilvolumen des Objekts für spektralanalytische oder bildgebende Messungen ausgewählt werden, wie dies in der europäischen Patentanmeldung 0184840 beschrieben wird, wobei bei jedem 90°-Impuls der Folge von drei Impulsen immer ein verschiedenes Gradientenmagnetfeld eingeschaltet wird. Mit dem vorbeschriebenen Verfahren ist es möglich, eine hochauflösende Abbildung eines geringen Teilvolumens anzufertigen. Jedoch eignet sich zum Spektralanalysieren obiges Verfahren besonders zum Wählen eines kleinen Volumens, hat aber den Nachteil, daß es mit dieser Folge nicht möglich, ist das Verfahren mit einer Wasserunterdrückungsmethodik anzuwenden. Diese Wasserunterdrückung ist bei der Messung beispielsweise von Metaboliten in Protonenspektren erforderlich. Die Unterdrückung der Wasserspitze ist notwendig, weil die Wasserprotonen die übergroße Mehrheit der angeregten Kernspins bilden.

Daher wird in der europäischen Patentanmeldung 0184840 vorgeschalgen, nach den drei räumlich selektiven 90°-Impulsen einen 180°-Nachfokussierungsimpuls abzugeben. Durch geeignete Wahl der Zeit zwischen den aufeinanderfolgenden ersten und zweiten 90°-Impulsen, zwischen den zweiten und den dritten 90°-Impulsen und zwischen dem dritten 90°-Impuls und dem 180°-Nachfokussierungsimpuls läßt sich die Wasserspitze unterdrücken, wie anhand der Fig. 36 der betreffenden Anmeldung beschrieben wurde.

Jedoch ergibt die vorgeschlagene Impulsfolge eine mäßige Unterdrückung der unerwünschten Komponente, weil diese Unterdrückung auf verschiedenen Relaxationszeitkonstanten basiert (T1-und T2-Relaxationszeitkonstanten). Weiter sei bemerkt, daß der nichtselektive 180°-Impuls nie ideal ist und Störsignale auslöst, die die Güte des aufgerufenen Echoresonanzsignals wesentlich beeinträchtigen.

Ein weiterer Nachteil der in der europäischen Patentanmeldung 0184840 beschriebenen Impulsfolgen ist, daß sie bei der Untersuchung von Material mit einer verhältnismäßig kurzen T2-Relaxationszeitkonstante nicht verwendet werden können.

Der Erfindung liegt die Aufgabe zugrunde, ein Verfahren anzugeben, mit dem eine Abwandlung einer Impulsfolge, die von E.L. Hahn in Physical Review, Vol. 80, Nr. 4, November 15, 1950 vorgeschlagen wurde, angewandt wird, und diese Abwandlung Verfahren bewirkt, die eine breitere Skala von Untersuchungsmethoden ergibt.

Der Erfindung liegt insbesondere die Aufgabe zugrunde, ein Verfahren anzugeben mit dem mit einer Folge verschiedener Hochfrequenzimpulse und der Verwendung zugeordneter verschiedener Gradientenmagnetfelder ein Teilvolumen ausgewählt wird, bei dem die Wasserunterdrückungstechnik besonders wirksam möglich ist.

Der Erfindung liegt weiter die Aufgabe zugrunde, ein Verfahren der vorliegenden Art anzugeben, daß sich besonders für Untersuchung von Material mit einer verhältnismäßig kurzen T2-Relaxationszeitkonstante eignet.

Zur Lösung dieser Aufgabe ist die Erfindung dadurch gekennzeichnet, daß die Folge wenigstens vier Hf-Impulse enthält, von denen ein erster Impuls ein frequenzselektiver 90°-Anregungsimpuls und entweder ein erster, folgender oder ein dritter, folgender Hf-Impuls ein Nachfokussierungsimpuls (180°-Impuls) ist. Durch die Anwendung eines frequenzselektiven Anregungsimpulses als Beginn der Impulsfolge ensteht der Zustand, bei dem eine vollständige Unterdrückung einer unerwünschten Resonanzlinie möglich ist.

Ein Ausführungsbeispiel eines Verfahrens nach der Erfindung ist dadurch gekennzeichnet, daß während eines der drei dem frequenzselektiven Impuls folgenden Hochfrequenzimpulse ein Gradientenmagnetfeld eingeschaltet ist. Ein derartiges Verfahren bietet den Vorteil, daß nur aus einem von der Bandbreite des Hochfrequenzimpulses und durch die Stärke und Richtung des Gradientenmagnetfelds beschränkten Teil des Objekts Signale gewonnen werden.

Ein anderes Ausführungsbeispiel eines erfindungsgemäßen Verfahrens ist dadurch gekennzeichnet, daß die Impulsfolge eine Reihenfolge von drei 90°-Hochfrequenzimpulsen und einem 180°-Hochfrequenzimpuls aufweist, wobei wenigstens für die Dauer des 180°-Impulses ein Gradientenfeld eingeschaltet ist. Ein derartiges Verfahren bietet den Vorteil, daß das nachfokussierte erzwungene Echosignal nur aus einem beschränkten gewünschten Teil des Objekts herrührt, was sich in einer Reduzierung von Stör- und Rauschsignalen im Echosignal vorteilhaft auswirkt.

Ein bevorzugtes Ausführungsbeispiel eines erfindungsgemäßen Verfahrens ist dadurch gekennzeichnet, daß der Nachfokussierungsimpuls der zweite Impuls in der Impulsfolge und für die Dauer des zweiten, dritten und vierten Anregungsimpulses stets ein anderes Gradientenfeld eingeschaltet ist. Mit dem bevorzugten Ausführungsbeispiel des erfindungsgemäßen Verfahrens wird in einem Objekt ein in drei Dimensionen beschränktes Teilvolumen gewählt, wobei Austastung einer unerwünschten Resonanzlinie im Spektrum möglich ist. Mit diesem Verfahren sind sowohl räumlich als auch im Spektrum hochauflösende Messungen verwirklichbar. Das Verfahren, bei dem ein hochauflösendes Bild des räumlich in drei Dimensionen beschränkten Teils des Objekts verwirklicht wird, ist dadurch gekennzeichnet, daß in einer Zeit nach einem Hochfrequenzimpuls, in dem eine Transversalmagnetisierung auftritt, ein Gradientenmagnetfeld angelegt wird. Mit diesem Verfahren ist es nicht nur möglich, beispielsweise eine räumliche Verteilung einer Magnetisierungsverteilung zu bestimmen, sondern weiter auch je Volumenelement ein Spektrum festzusetzen, in dem eine Streuspitze des Spektrums (beispielsweise eine derart vorherrschende Spitze, daß sie die übrigen Spitzen im Spektrum mit einer größeren Anzahl von Informationseinzelheiten überstrahlt) ausgetastet ist.

Das Verfahren nach diesem Ausführungsbeispiel bietet den Vorteil, daß kurz von Beginn der Datenerfassung ein Leseimpuls vorliegt, d.h. ein 90°- oder ein $\alpha$°-Impuls ($\alpha < 90°$), daher treten minimale Störungen im aufgerufenen erzwungenen Echo auf. Dies findet darin ihre Ursache, daß mit dem Anregungsimpuls nur Signale aufgerufen werden, die aus den von diesem Anregungsimpuls aus ihrer Längsmagnetisierung gebrachten Kernspinns herrühren. Dieser Zustand bringt die Möglichkeit in der diesem Leseimpuls vorangehenden Zeit, alle dabei vorhandenen transversal-magnetisierten Kernspins mittels eines Gradientenmagnetfelds aus der Phase zu bringen. Mit diesem vorgeschlagenen Verfahren nach der Erfindung läßt sich auch die sog. Mehrschnitt-Technik durchzuführen, wobei in einer Meßfolge verschiedene Teile eines Objekts unabhängig voneinander abtastbar sind. Bei dem eingereichten erfindungsgemäßen Verfahren ist es möglich, mit nur einer kurzen zusätzlichen Meßdauer die einzelnen Teile zu messen, weil nur die verschiedenen erforderlichen Leseimpulse mit je einer verschiedenen Zentralfrequenz erzeugt zu werden brauchen.

Bei der Anwendung von $\alpha$°-Impulsen als Leseimpuls entsteht nunmehr die Möglichkeit, mit einem ersten Impuls ein Echosignal aufzurufen, das bei Abwesenheit eines Gradientenmagnetfelds zur Bestimmung eines georteten Spektrums abgetastet wird, wonach mit einem zweiten $\alpha$°-Impuls ein zweites Echo erzeugt wird, das bei einem Gradientenfeld zur Bestimmung einer Dichteverteilung mit sehr hohem Auflösungsvermögen (zoom imaging) gemessen wird.

Ein Ausführungsbeispiel des erfindungsgemäßen Verfahrens ist dadurch gekennzeichnet, daß nach einem Leseimpuls wenigstens ein weiterer Nachfokussierungsimpuls erzeugt wird. Dieses Ausführungsbeispiel des erfindungsgemäßen Verfahrens bietet den Vorteil, daß auch Mehrechosignale erhalten werden.

Das erfindungsgemäße Verfahren nach obiger Beschreibung bietet dieselben Möglichkeiten wie die stimulierten Standard-Echofolgemethodiken, gibt aber laut Angabe außerdem noch zusätzliche Meßmöglichkeiten was vorteilhaft ist, jedoch sind bei dem vorbeschriebenen Verfahren die angewandten Hochfrequenzimpulse (90° oder 180°) nicht kritisch. Abweichungen von den nicht idealen Kippwinkeln 90° und 180° sind erlaubt, ohne daß dies zu großen Einfluß auf die Qualität ($S/N$) der gemessenen Signale hat.

Ausführungsbeispiele der Erfindung werden nachstehend anhand der Zeichnung näher erläutert. Es zeigen

Fig. 1 eine erfindungsgemäße Anordnung,

Fig. 2 ein Ablaufdiagramm einer bekannten Impulsfolge zum Erzeugen eines stimulierten Echos aus einem Teilvolumen eines Objekts,

Fig. 3 ein Ablaufdiagramm eines Verfahrens mit der erfindungsgemäßen Impulsfolge, und

Fig. 4 ein Ablaufdiagramm eines bevorzugten Ausführungsbeispiels eines erfindungsgemäßen Verfahrens.

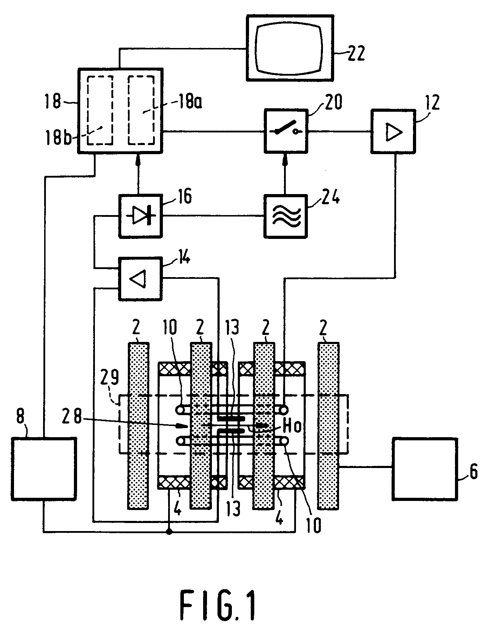

In Fig. 1 ist ein magnetisches Resonanzmeßgerät mit einem Magnetsystem 2 zum Erzeugen eines statischen Magnetfelds HO, mit einem Magnetsystem 4 zum Erzeugen von Gradientenmagnetfeldern und mit Speisequellen 6 und 8 für das Magnetsystem 2 bzw. das Magnetsystem 4 dargestellt. Eine Hf-Magnetspule 10 dient zum Erzeugen eines magnetischen Hf-Wechselfeldes und ist dazu an eine Hf-Quelle 12 angeschlossen. Für die Detektion des vom Hf-Sendefeld erzeugten Resonanzsignals in einem zu untersuchenden Objekt wird eine Hf-Spule 13 benutzt, die dazu mit einem Signalverstärker 14 verbunden ist. Der Signalverstärker 14 ist mit einem Detektor 16 verbunden, der an eine zentrale Verarbeitungseinheit 18 angeschlossen ist. Die zentrale Verarbeitungsanordnung 18 steuert weiter einen Modulator 20 für die Hf-Quelle 12, die Speisequelle 8 für die Gradientenmagnetspulen und einen Monitor 22 für die Bildwiedergabe. Ein Hf-Oszillator 24 speist sowohl den Modulator 20 als auch den Detektor 16. Die in den Magnetsystemen 2 und 4 angeordnete Sendespule 12 umschließt einen Meßraum 28, in dem ein zu untersuchendes Objekt angeordnet werden kann. Im Meßraum 28 können ein statisches Magnetfeld HO, Objektschnitt wählende Magnetfelder und ein räumliches homogenes Magnetwechselfeld erzeugt werden. Der Meßraum 28, die Sendespule 12 und die Empfangsspule 13 sind von einem Hf-Signal abschirmenden Käfig 29 umschlossen, der die Umgebung gegen die im Messraum 28 auftretenden Hf-Signalen abschirmen soll. Die zentrale Verarbeitungsanordnung 18 enthält eine Signalverarbeitungseinheit 18a und eine Steuereinheit 18b. Die Signalverarbeitungseinheit 18a verarbeitet die aus der Empfangsspule 13 ankommenden Signale beispielsweise zu zweidimensionalen Bildern (2D-Dichteverteilungen, Spektren) die am Monitor 22 angebildet werden. Die Steuereinheit 18b enthält programmierbare Steueremittel, die sowohl den Modulator 20 als auch die Magnetspeisung 8 ansteuern, wodurch mit der in Fig. 1 dargestellten Anordnung Meßfolgen durchführbar sind, die aus Zyklen von Hf-Impulssequenzen bestehen, die möglicherweise in Zusammenarbeit mit Gradientenmagnetfeldern angelegt werden. Auf diese Weise sind in einem Objekt oder in einem Teil eines Objekts Kernspins anregbar, wobei die Position der angeregten Kernspins von den zugeführten Hf-Impuls abhängig ist, insbesondere von seiner Frequenz, und von den angelegten Gradientenmagnetfeldern in Zusammenarbeit mit dem vorhandenen statischen Magnetfeld HO.

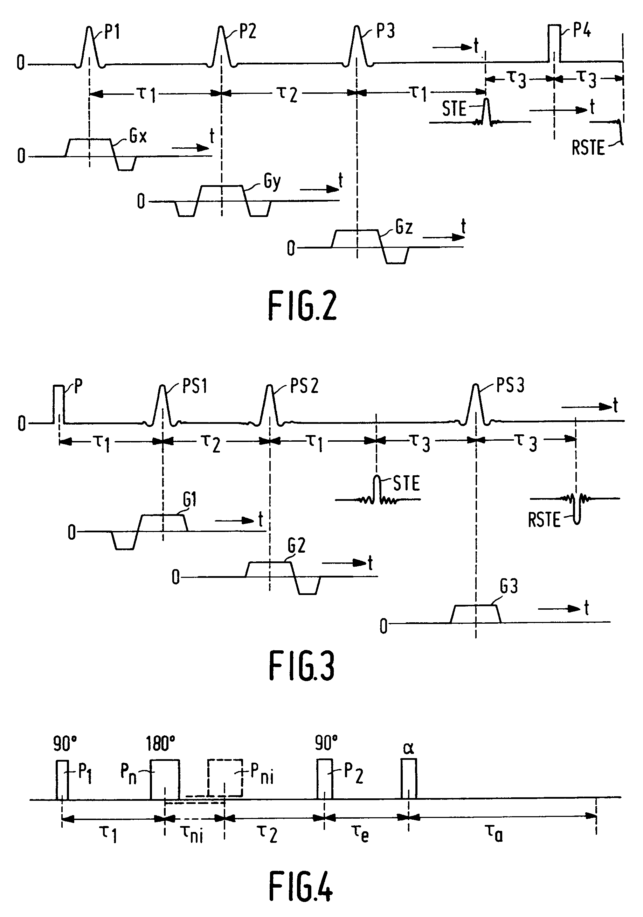

In Fig. 2 ist ein Ablaufdiagramm einer Impulsfolge zum Erzeugen stimulierter Echos dargestellt. Die Impulssequenz enthält drei 90°-Hf-Impulse P1, P2 und P3, zwischen denen die Zeiten $\tau 1$ und $\tau 2$ ablaufen. Beim ersten 90°-Impuls P1 wird ein erstes Gradientenmagnetfeld Gx angelegt, während beim zweiten und beim dritten 90°-Anregungsimpuls P2 und P3 ein Wahlgradient Gy bzw. Gz angelegt werden. Aus der Veröffentlichung von Frahm und anderen, Journal of Magnetic Resonance, 64, S. 81...93, 1985, ist ableitbar, daß diese Impulsfolge ein stimuliertes Echo STE aus einem Teilgebiet eines Objekts erzeugt, das von den drei verschiedenen Gradientenmagnetfeldern Gx, Gy und Gz bestimmt wird. Jedoch hat dieses Verfahren den Nachteil, daß beim Anregen von Protonen die Wasserspitze in bezug auf die chemisch gebundenen Protonen, die in viel geringeren Anzahlen auftreten, besonders stark ist. Die Beantwortungen der ungebundenen Protonen sind also dem erzeugten stimulierten Echosignal überlegen. Die gewünschten Signale der chemisch gebundenen Protonen werden dadurch gewissermaßen überstrahlt, was unerwünscht ist. Daher ist in der europäischen Patentanmeldung 0184840 vorgeschlagen, nach den drei 90°-Impulsen P1, P2 und P3 einen vierten Puls P4 (einen nicht selektiven 180°-Impuls) zu erzeugen, so daß bei geeigneter Wahl von $\tau 1$, $\tau 2$ und $\tau 3$ ein nachfokussiertes stimuliertes Echo RSTE erzeugt wird, in dem die Wasserspitze oder eine andere unerwünschte Spitze unterdrückt wird. Wie oben bereits beschrieben, sind die mit der in Fig. 2 dargestellten Folgen zu erzielenden Ergebnisse unbefriedigend.

In Fig. 3 ist eine Impulsfolge zum Erzeugen stimulierter Echos dargestellt, in der der obige Nachteil vermieden ist. Die Folge enthält drei aufeinanderfolgende 90°-Impulse, von denen der erste Impuls P nicht räumlich selektiv, sondern frequenzselektiv ist, der zweite Impuls PS1 bei einem Gradientenfeld G1 und der dritte 90°-Anregungsimpuls PS2 bei einem Gradientenfeld G2 angelegt werden. Es wird ein stimuliertes Echo STE mit dieser Folge erzeugt. Indem ein 180°-Impuls PS3 bei einem selektiven Gradienten G3 angewandt wird, wird ein nachfokussiertes stimuliertes Echo RSTE erzeugt, das aus einem Volumen herrührt, das von den angelegten Gradientenmagnetfeldern G1, G2 und G3 bestimmt ist, von denen die Gradientenrichtungen senkrecht zueinander verlaufen.

In Fig. 4 ist das bevorzugte Ausführungsbeispiel eines erfindungsgemässen Verfahrens dargestellt. Die Meßfolge startet mit einem Impuls P1, einem 90°-Anregungsimpuls, und dieser Meßfolge folgt nach einer Wartezeit $\tau 1$ wenigstens ein 180°-Zeitumkehrimpuls Pn. Ggf. folgt dem 180°-Impuls Pn nach einer Wartezeit $\tau ni$ ein weiterer oder mehrere Hf-Impulse Pni, wobei zwischen den verschiedenen 180°-Hf-Impulsen die Wartezeiten $\tau ni$ ungleich sein können. Der weitere Hf-Impuls Pni kann beispielsweise ein frequenzselektiver Impuls sein, um wilde Anregungen entphasieren zu lassen, ggf. mit einem darin einzuschaltenden Gradientenmagnetfeld. Die Folge von 180°-Impulsen kann identische (z.B frequenzselektive) Impulse enthalten, wodurch eine Signalverbesserung erhalten wird (z.B. Wasserspitzenunterdrückung). Nach dem zuletzt gegebenen 180°-Zeitumkehrimpuls Pni oder Pn erscheint nach einer Wartezeit $\tau 2$ ein zweiter 90°-Anregungsimpuls P2. Während und/oder zwischen den erwähnten 90°- oder 180°-Impulsen P2, Pn oder Pni oder Pn2 können möglicherweise Gradientenmagnetfelder angelegt werden. Zum selektiven Anregen eines bestimmten Teils eines zu messenden Objekts ist während den Impulsen Pn, Pni oder P2 ein Gradientenmagnetfeld anzulegen. Die Impulse haben dabei eine räumlich selektive Wirkung.

In den Zeiträumen $\tau 1$, $\tau ni$, $\tau 2$ kann ein Gradientenmagnetfeld angelegt werden, um entweder angeregten Kernspins eine räumlich abhängige Phasencodierung zu geben oder gerade um eine Entphasierung unter Kernspins zu bewirken, die nach einem Hf-Leseimpuls keinen Signalbeitrag liefern dürfen. Die mögliche Verwendung von Gradientenmagnetfeldern nach der Beschreibung anhand der Fig. 3 ist auch beim Meßzyklus möglich, der anhand der Fig. 2 beschrieben ist, wobei jedoch der 180°-Impuls vorzugsweise ein räumlich selektiver Impuls ist beim Messen an Objekten mit örtlich abhängigen Verteilungen (Spektren).

Beim beschriebenen erfindungsgemäßen Verfahren und bei dem in Fig. 4 dargestellten Beispiel eines Meßzyklus ist Mehrscheiben technik sehr gut möglich. So ist es beispielsweise möglich mit den drei Hf-Impulsen, u.zw. dem ersten und dem zweiten 90°-Anregungsimpuls P1 und P2 und dem 180°-Impuls Pn, einen bestimmten Teil eines Objekts selektiv anzuregen, wonach mit einem selektiven α-Impuls ein Unterteil in diesem Teil angeregt und das daraus aufgerufene Resonanzsignal während der Erfassungszeit τ a nach diesem α-Impuls, abgetastet wird. Nach dieser Erfassungszeit τ a wird ein weiterer α-Impuls wenn auch ein selektiver α-Impuls ausgegeben, die eine abweichende Sendefrequenz hat. Mit der Anwendung eines α-Impulses mit abweichender Sendefrequenz in Zusammenarbeit mit einem angelegten Gradientenfeld wird erreicht, daß ein anderer Unterteil des angelegten Teils des Objekts angelegt wird, so daß jetzt daraus Resonanzsignale gewonnen werden. Obiger Vorgang kann jetzt immer nach einem Erfassungszeitraum τ a wiederholt werden, wobei dann stets ein α-Impuls mit einer abweichenden zentralen Frequenz beim gleichen angelegten Gradientenmagnetfeld ausgegeben wird. Dies läßt sich so einrichten, daß immer die abgetasteten Unterteile schließlich den gesamten angeregten Teil des Objekts bilden. Selbstverständlich wird bei der Anwendung verschiedener Gradientenmagnetfelder auch immer eine verschiedene Schichtdicke gewählt.

Das eingereichte Verfahren erlaubt die Anwendung von Nachfokussierungsimpulsen nach Ablauf der in Fig. 2 dargestellten Meßsequenz, so daß dadurch Mehrechosignale erhalten werden.

Das in Fig. 4 dargestellte Verfahren eignet sich besonders zur Durchführung von Messungen an Materie mit einer kurzen T2-Relaxationszeitkonstante, weil das Verfahren den Vorteil bietet, daß die wirksame Meßzeit, (d.h. der Einfluß der Zeit auf die Kernspins) durch Anwendung des (räumlich selektiven) 180°-Impulses verkürzt ist.

Die anhand der Fig. 3 und 4 beschriebenen Verfahren eignen sich hervorragend für spektralanalytische Untersuchungen, insbesondere räumlich gelöste (phasencodierte) Spektren in einem (kleinen) Teilvolumen in einem Objekt (chemische Verschiebungsabbildung ; Spektralaufbereitung), was für die Messung von Metaboliten in Protonen spektren besonders vorteilhaft ist. Obiges wird anhand eines Beispiels bei Laktatuntersuchung näher erläutert. Das Laktatmolekül enthält (abgesehen von Sauerstoffatomen und OH-Verbindungen) einen Kohlenstoffatom, mit dem ein Wasserstoffproton, das α-Proton und eine $CH_3$-Gruppe verbunden sind, die bei der magnetischen Resonanwasserstoffuntersuchung nach der Anregung Signale ausgeben. Das α-Proton liefert ein Resonanzsignal (α-Spitze), das direkt neben der Resonanzlinie der in $H_2O$ gebundenen Wasserstoffatome liegt. Die $CH_3$-Gruppe liefert ein Resonanzsignal, das eine etwas größere chemische Verschiebung σ als die des α-Protons zeigt, und also im Spektrum Spitzen aufweist, bei denen die α-Spitze zwischen diesen Spitzen und der sehr starken Resonanzspitze der in $H_2O$ gebundenen Protonen

liegt. Die $CH_3$-Gruppe der Laktatmoleküle liefern zwei Spitzen (Resonanzfrequenzunterschied 7 Hz), weil eine $CH_3$-Gruppe das α-Proton entweder als einen positiven Magnetdipol oder als einen negativen Magnetdipol sehen.

Die Anwendung eines Meßzyklus nach Fig. 3 oder 4 zeigt jetzt die Unterdrückung der kräftigen Wasserspitze, so daß ein örtlich gemessenes Spektrum klar die α-Spitze und die zwei Spitzen der $CH_3$-Gruppe zeigt. Die beiden letztgenannten Spitzen sind jetzt besonders wichtig. Indem jetzt der Meßzyklus zweimal durchgeführt wird, wobei im einen Fall das Frequenzspektrum der 180° tatsächlich die α-Spitze umfaßt und im anderen Fall nicht, fällt beim Addieren der aus den Messungen errechneten Spektren die α-Spitze aus und die zwei Spitzen der $CH_3$-Gruppe werden verstärkt. Selbstverständlich können auch erst die gemessenen Resonanzsignale addiert werden, so daß das aus den addierten Resonanzsignalen errechnete Spektrum keine α-Spitze, sondern verstärkte $CH_3$-Spitzen aufweist.

Die anhand der Fig. 3 und 4 beschriebene Wasserunterdrückungsmethodik läßt sich weiter durch Ausgeben eines oder mehrerer schmalbandiger (20 Hz), auf die Resonanzlinie von Wasser abgestimmter 90°-Anregungsimpulse vor den wiedergegebenen Zyklen optimieren, wobei diesen Anregungsimpulsen ein entphasierendes Gradientenfeld folgt, so daß vor dem chemisch selektiven Anregungsimpuls die Kernspins der Wasserprotonen bereits vollständig entphasiert sind. Auch kann nach dem zweiten 90°-Anregungsimpuls in den Meßzyklen der Fig. 3 und 4 ein weiterer schmalbandiger (20 Hz) und auf die Resonanzlinie von Wasserprotonen abgestimmter 90°-Impuls ausgegeben werden, dem ebenfalls ein die transversal magnetisierten Wasserprotonen entphasierendes Gradientenmagnetfeld folgt.

## Patentansprüche

1. Verfahren zur Bestimmung einer wasserunterdrückten Kernmagnetisierungsverteilung wenigstens in einem Teil eines Objekts, wobei mittels einer Folge von Hf-Impulsen möglicherweise in Zusammenarbeit mit verschiedenen Gradientenmagnetfeldern wenigstens der Teil des Objekts angeregt und ein stimuliertes Echo erzeugt wird, das abgetastet wird, dadurch gekennzeichnet, daß die Folge wenigstens vier Hf-Impulse enthält, von denen ein erster Impuls ein frequenzselektiver 90°-Anregungsimpuls und entweder ein erster, folgender oder ein dritter, folgender Hf-Impuls ein 180°-Nachfokussierungsimpuls ist.

2. Verfahren nach Anspurch 1, dadurch gekennzeichnet, daß während wenigstens eines der drei dem frequenzselektiven Impuls folgenden Hf-Impulse ein Gradientenmagnetfeld eingeschaltet ist.

3. Verfahren nach Anspruch 1 oder 2, dadurch gekennzeichnet, daß die Impulsfolge eine Reihenfolge von drei 90°- und einem 180°-Hf-Impulsen enthält, wobei wenigstens während des 180°-Impuls es ein Gradientenfeld eingeschaltet ist.

4. Verfahren nach Anspruch 1 oder 2, dadurch gekennzeichnet, daß der Nachfokussierungsimpuls der zweite Impuls in der Impulsfolge ist und während dem zweiten, dritten und vierten Impuls stets ein anderes Gradientenfeld eingeschaltet ist.

5. Verfahren nach Anspruch 1, dadurch gekennzeichnet, daß dem frequenzselektiven Impuls ein Zyklus von n 180°-Impulsen folgt, wobein $\geqq 2$ ist und die Impulse frequenzselektiv oder in Zusammenarbeit mit einem Gradientenmagnetfeld räumlich selektiv sein können, wobei die Zeiträume zwischen den 180°-Impulsen einstellbar sind.

6. Verfahren nach Anspruch 5, dadurch gekennzeichnet, daß der Zyklus von n 180°-Impulsen ausschließlich identische Impulse enthält.

7. Verfahren nach Anspruch 1, 2 oder 4, dadurch gekennzeichnet, daß die beiden Hf-Impulse nach dem 180°-Impuls oder den 180°-Impulsen ein 90°-Impuls bzw. ein Leseimpuls sind, wobei der Leseimpuls ein $\alpha$°-Impuls ist, wobei $\alpha \leq$ 90° ist.

8. Verfahren nach einem der vorangehenden Ansprüche, dadurch gekennzeichnet, daß in einer Zeit nach einem Hf-Impuls, in der eine transversale Magnetisierung vorhanden ist, ein Gradientenmagnetfeld angelegt wird.

## Claims

1. A method of determing a water-suppressed nuclear magnetization distribution in at least a region of an object where using a sequence of rf pulses, possibly in combination with different gradient magnetic fields, at least the regio of the object is excited and a stimulated echo is generated and sampled, characterized in that the sequence comprises at least four rf pulses, a first pulse of which is a frequency-selective 90° excitation pulse, either a first-following rf pulse or a third-following rf pulse being a refocusing pulse (180° pulse).

2. A method as claimed in Claim 1, characterized in that a gradient magnetic field is activated during at least one of the three rf pulses succeeding the frequency-selective pulse.

3. A method as claimed in Claim 1 or 2, characterized in that the pulse sequence comprises a sequence of three 90° rf pulses and one 180° rf pulse, a gradient field being activated at least during the 180° pulse.

4. A method as claimed in Claim 1 or 2, characterized in that the refocusing pulse is the second pulse of the pulse sequence, each time a different gradient field being activated during the second, the third and the fourth pulse.

5. A method as claimed in Claim 1, characterized in that the frequency-selective pulse is followed by a cycle of n 180° pulses, where n $\geq$ 2 and that the pulses can be frequency-selective or spatially selective, in combination with a gradient magnetic field, the periods between the 180° pulses being adjustable.

6. A method as claimed in Claim 5, characterized in that the cycle of n 180° pulses comprises only identical pulses.

7. A method as claimed in Claim 1, 2 or 4, characterized in that the two rf pulses succeeding the 180° pulse or 180° pulses are a 90° pulse and a read pulse, respectively, the read pulse being an $\alpha$° pulse, where $\alpha \leq$ 90°.

8. A method as claimed in any one of the preceding Claims, characterized in that a gradient magnetic field is applied during a period which succeeds an rf pulse and in which a transverse magnetization is present.

## Revendications

1. Procédé pour la détermination d'une répartition de la magnétisation nucléaire avec suppression de l'eau d'au moins une partie d'un objet, où au moins la partie de l'objet est excitée au moyen d'une séquence d'impulsions de haute fréquence, éventuellement en collaboration avec des champs magnétiques de gradient différents et un écho stimulé, qui est analysé, est produit, caractérisé en ce que la séquence comprend au moins quatre impulsions de haute fréquence, parmi lesquelles une première impulsion est une impulsion d'excitation à 90° sélective en fréquence et une première ou une troisième impulsion de haute fréquence suivante est une impulsion de refocalisation (impulsion à 180°).

2. Procédé suivant la revendication 1, caractérisé en ce qu'un champ magnétique de gradient est enclenché pendant au moins une des trois impulsions de haute fréquence succédant à l'impulsion sélective en fréquence

3. Procédé suivant la revendication 1 ou 2, caractérisé en ce que la séquence d'impulsions comprend une succession de trois impulsions de haute fréquence à 90° et d'une à 180°, un champ de gradient étant enclenché au moins pendant l'impulsion à 180°.

4. Procédé suivant la revendication 1 ou 2, caractérisé en ce que l'impulsion de refocalisation est la deuxième impulsion de la succession d'impulsions et un champ de gradient différent est chaque fois enclenché pendant la deuxième, la troisième et la quatrième impulsion.

5. Procédé suivant la revendication 1, caractérisé en ce que l'impulsion sélective en fréquence est suivie d'un cycle de n impulsions à 180°, étant entendu que n $\geq$ 2 et que les impulsions peuvent être sélectives en fréquence ou sélectives dans l'espace en collaboration avec un champ magnétique de gradient, tandis que les durées entre les impulsions à 180° peuvent être ajustées.

6. Procédé suivant la revendication 5, caractérisé en ce que le cycle de n impulsions à 180° contient uniquement des impulsions identiques.

7. Procédé suivant la revendication 1, 2 ou 4, caractérisé en ce que les deux impulsions de haute fréquence après l'impulsion à 180° ou les impulsions à 180° sont une impulsion à 90° et une impulsion de lecture, l'impulsion de lecture étant une impulsion à $\alpha°$ avec $\alpha \le 90°$.

8. Procédé suivant l'une quelconque des revendications précédentes, caractérisé en ce qu'un champ magnétique de gradient est appliqué pendant une durée après une impulsion de haute fréquence au cours de laquelle une magnétisation transversale existe.

FIG.1

FIG.2

FIG.3

FIG.4